(19)

**Europäisches Patentamt**
**European Patent Office**
**Office européen des brevets**

(11) **EP 0 724 026 B1**

(12) # EUROPÄISCHE PATENTSCHRIFT

(45) Veröffentlichungstag und Bekanntmachung des Hinweises auf die Patenterteilung:
**13.10.1999 Patentblatt 1999/41**

(51) Int Cl.⁶: **C23C 16/50**, C23C 16/04, C23C 16/44, H01J 37/00, H05H 1/48

(21) Anmeldenummer: **96100200.3**

(22) Anmeldetag: **09.01.1996**

(54) **Verfahren zur reaktiven Schichtabscheidung**

Process for reactive coating

Procédé de dépôt réactif

(84) Benannte Vertragsstaaten:
**CH DE FR GB LI SE**

(30) Priorität: **25.01.1995 CH 20095**
**10.07.1995 US 499989**

(43) Veröffentlichungstag der Anmeldung:
**31.07.1996 Patentblatt 1996/31**

(73) Patentinhaber: **BALZERS AKTIENGESELLSCHAFT**
**9496 Balzers (LI)**

(72) Erfinder:
- **Karner, Johann, Dr.**
  **A - 6800 Feldkirch (AT)**
- **Pedrazzini, Mauro**
  **FL - 9492 Eschen (LI)**
- **Bergmann, Erich, Dr.**
  **CH-2560 Nidau (CH)**

(74) Vertreter: **Troesch Scheidegger Werner AG**
**Patentanwälte,**
**Siewerdtstrasse 95,**
**Postfach**
**8050 Zürich (CH)**

(56) Entgegenhaltungen:
**EP-A- 0 478 909**
**WO-A-92/20464**
**GB-A- 2 176 808**

- **39TH AMERICAN VACUUM SOCIETY NATIONAL SYMPOSIUM, CHICAGO, IL, USA, 9-13 NOV. 1992, Bd. 11, Nr. 4, pt.1, ISSN 0734-2101, JOURNAL OF VACUUM SCIENCE & TECHNOLOGY A (VACUUM, SURFACES, AND FILMS), JULY-AUG. 1993, USA, Seiten 1486-1490, XP002002399 BARDOS L ET AL: "Radio frequency plasma jet applied to coating of internal walls of narrow tubes"**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).



Printed by Jouve, 75001 PARIS (FR)

## Beschreibung

Die vorliegende Erfindung betrifft ein Verfahren nach dem Oberbegriff von Anspruch 1 sowie eine Vakuumbehandlungsanlage nach demjenigen von Anspruch 16 und Verwendungen des Verfahrens bzw. der Anlage nach den Ansprüchen 14, 15 bzw. 23, 24.

Aus der CH-PS 664 768 sowie der GB-A-2 176 808 ist ein Verfahren eingangs genannter Art bekannt, bei welchem, als Plasmastrahl, eine Niederspannungs-Bogenentladung mit Heisskathode eingesetzt wird, wobei Werkstücke im wesentlichen parallel zur Strahlachse, diesbezüglich radial versetzt, also ausserhalb des Bereiches höchster Plasmadichte entlang dieser Achse angeordnet werden.

Reaktivgas wird, bezüglich der Strahlachse diametral den Werkstücken gegenüberliegend, eingedüst. Das eingelassene Reaktivgas reagiert im Plasma und an der Oberfläche der zu beschichtenden Werkstücke, ein Reaktionsprodukt wird als Schicht auf die Werkstückoberflächen abgeschieden. Nebst verbleibendem frischem Reaktivgas und dem Arbeitsgas, üblicherweise einem Edelgas, wie Argon, werden aus dem Rezipienten auch gasförmige Reaktionsprodukte abgesaugt.

Nachteilig ist, dass in der erwähnten Anordnung keine reine metastabilen Schichten grossflächig abgeschieden werden könnten.

Spezifisch für die Diamantschichtabscheidung ist es im weiteren aus der DE 40 29 270, entsprechend der EP-A-478 909, bekannt, einerseits, vermeintlich für die Diamantabscheidung notwendig, eine höhere Plasmadichte als gemäss der CH 664 768 auszunützen, dabei gleichzeitig zu ermöglichen, grössere Werkstückoberflächen oder mehr Werkstücke gleichzeitig homogen zu beschichten.

Dies wird gemäss letzterwähnter Schrift dadurch erreicht, dass eine Mehrzahl einzelner Plasmastrahlen nebeneinander erzeugt werden, womit eine räumlich verteilte, gleichmässig hohe Plasmadichte realisiert wird.

In dieser Schrift ist anhand eines Beispiels beschrieben, die Werkstücke bezüglich eines gebündelten Plasmastrahls im Bereich von ca. 50% der maximalen Plasmadichte anzuordnen. Gefunden wird, dass es so schwierig ist, reproduzierbar gleiche Schichtqualität über grössere Flächen zu erreichen.

Aus der WO92/20464 ist es bekannt, um die Achse eines Plasmastrahls zu behandelnde Werkstükke zu gruppieren, und zwar je weiter von der Strahlausmündung entfernt, desto enger um die Strahlachse gruppiert.

Im weiteren wird auf folgende Schriften verwiesen:

- 39th AMERICAN VACUUM SOCIETY NATIONAL SYMPOSIUM, CHICAGO, IL, USA, 9-13 Nov. 1992, Bd. 11, Nr. 4, pt.1, ISSN 0734-2101, JOURNAL OF VACUUM SCIENCE & TECHNOLOGY A (VACUUM, SURFACES, AND FILMS), JULY-AUG. 1993, USA, S. 1486-1490;
- BARDOS L ET AL 'Radio frequency plasma jet applied to coating of internal walls of narrow tubes', S. 1487.

Die vorliegende Erfindung setzt sich zur Aufgabe, ausgehend vom eingangs genannten Vorgehen, ein Behandlungsverfahren zu schaffen, bei welchem nun aber grössere Werkstückoberflächen bzw. mehr Werkstücke gleichzeitig reproduzierbar homogen behandelt, insbesondere beschichtet werden können, d.h. grosstechnisch wirtschaftlich, und welches sich ganz allgemein zur Abscheidung von schwierig herstellbaren metastabilen Schichten, insbesondere von Diamant-, cBN-, $\alpha$-$Al_20_3$- oder $C_3N_4$-Schichten eignet.

Zu diesem Zweck zeichnet sich das eingangs erwähnte Verfahren nach dem kennzeichnenden Teil von Anspruch 1 aus. Insbesondere die Ausnützung von Plasmabereichen mit tiefer Dichte und/oder die Ausnützung einer Niederspannungs-Bogenentladung nach dem in Anspruch 1 genannten Prinzip ermöglichen erstaunlicherweise nebst der erwähnten allgemeinen Behandlung, bevorzugt den erwähnten allgemeinen Beschichtungen auch das Ablegen der erwähnten schwierig herstellbaren metastabilen Schichten, wie der erwähnten Diamant, cBN-, $\alpha$-$Al_20_3$- oder $C_3N_4$-Schichten und dies nun tatsächlich grosstechnisch wirtschaftlich.

Der Ausdruck "metastabil" wird nachfolgend gemäss Definition in "Lehrbuch der anorganischen Chemie", Holleman-Wiberg, Walter de Gruyter, Berlin, New York 1976, 81. - 90. Auflage, S. 183, verstanden.

In den Ansprüchen 2 bis 13 sind bevorzugte Ausführungsvarianten des erfindungsgemässen Verfahrens, in den Ansprüchen 16 bis 22 der erfindungsgemässen Anlage spezifiziert, in den Ansprüchen 14, 15 bzw. 23, 24 bevorzugte Verwendungen des genannten Verfahrens bzw. der genannten Anlage.

Im Gegensatz zum Verfahren gemäss der DE 4 029 270, wo die Werkstücke im Bereich hoher Plasmadichte eines homogen verteilten Plasmas angeordnet werden (oder zumindest in einem Bereich von 50% der maximalen Plasmadichte), wurde erfindungsgemäss erkannt, dass bei der Erzeugung eines extrem dichten Plasmas in einem dünnen Kanal, insbesondere bevorzugterweise durch einen Hochstrombogen genügend hohe Plasmadichten in relativ weiter Entfernung vom Bogen erzielt werden, um dort gar Diamantschichten abscheiden zu können. Dabei werden insbesondere im Hochstrombogen so extrem hohe Plasmadichten erzeugt, dass die Plasmadichte am Ort der Substrate zur Diamantabscheidung nur mehr einige % der maximalen Plasmadichte im Hochstrombogenzentrum beträgt.

Die Erfindung wird anschliessend beispielsweise anhand von Figuren erläutert.

Diese zeigen:

Fig. 1 schematisch einen Hochstrombogen und die diesbezügliche erfindungsgemässe Anordnung von zu beschichtenden Werkstücken,

Fig. 2 beispielsweise die Ionensättigungsstrom-Dichteverteilung auf einer Strahlquerebene gemäss Fig. 1, bei unterschiedlichen Entladungsströmen,

Fig. 3 schematisch eine erfindungsgemässe Anlage mit bevorzugter Form des erfindungsgemäss eingesetzten Werkstückträgers, (Fig. 3a)

Fig. 4 fünf typische Temperaturverläufe über der Diamantbeschichtungszeit eines erfindungsgemässen Diamantbeschichtungsprozesses gemäss Beispiel 1, wobei die fünf Verläufe an spezifischen Punkten entlang des Werkstückträgers gemäss Fig. 3 aufgenommen sind,

Fig. 5 anhand von REM-Aufnahmen, die Facettierung gleichzeitig abgelegter Diamantschichten nach Beispiel 1 an unterschiedlichen Stellen des Werkstückträgers nach Fig. 3,

Fig. 6 das Raman-Spektrum der gemäss Beispiel 1 abgelegten Diamantschicht,

Fig. 7 das Röntgenbeugungsspektrum der erwähnten abgelegten Diamantschicht auf Hartmetallsubstrat.

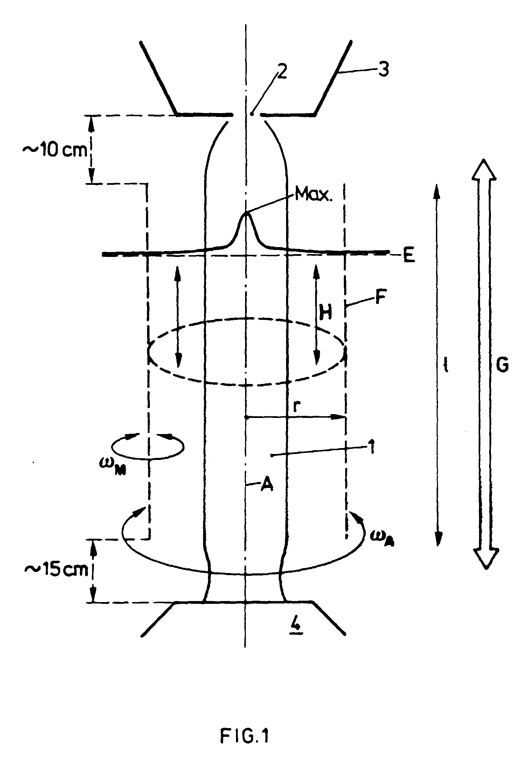

Anhand von Fig. 1 soll nun das grundsätzliche Vorgehen gemäss der vorliegenden Erfindung erläutert werden. Der bevorzugt als Hochstrombogen 1 ausgebildete Plasmastrahl divergiert nach einer Blendenöffnung 2 einer Kathodenkammer 3 rasch, innerhalb einiger cm, auf eine bestimmte Ausdehnung, um dann eine weitgehend konstante Ausbildung bis knapp vor die Anode, bis einige cm davor, beizubehalten. Die Ausdehnung des Bogens vor der Anode ist von der geometrischen Form der Anode abhängig. Damit ergibt sich bis auf einen kleinen Bereich nach der Blendenöffnung 2 und über der Anode 4 ein weitgehend homogener, langer Bereich $\ell$ des Hochstrombogens. Entlang der Strahlachse A ergeben sich in diametralen Schnittebenen E, wie beispielsweise eingetragen, glockenkurvenförmige Verteilungen der Plasmadichte. In jeder Ebene E weist die Plasmadichteverteilung eine Maximalstelle Max auf.

Je nach Anlagekonfiguration und Betrieb betragen die Abstände von Kathode und Anode, bei denen der Strahl homogen wird, einige cm, wie in einer beispielsweisen Realisation ca. 15cm bzw. ca. 10cm, wie in Fig. 1 als Beispiel eingetragen.

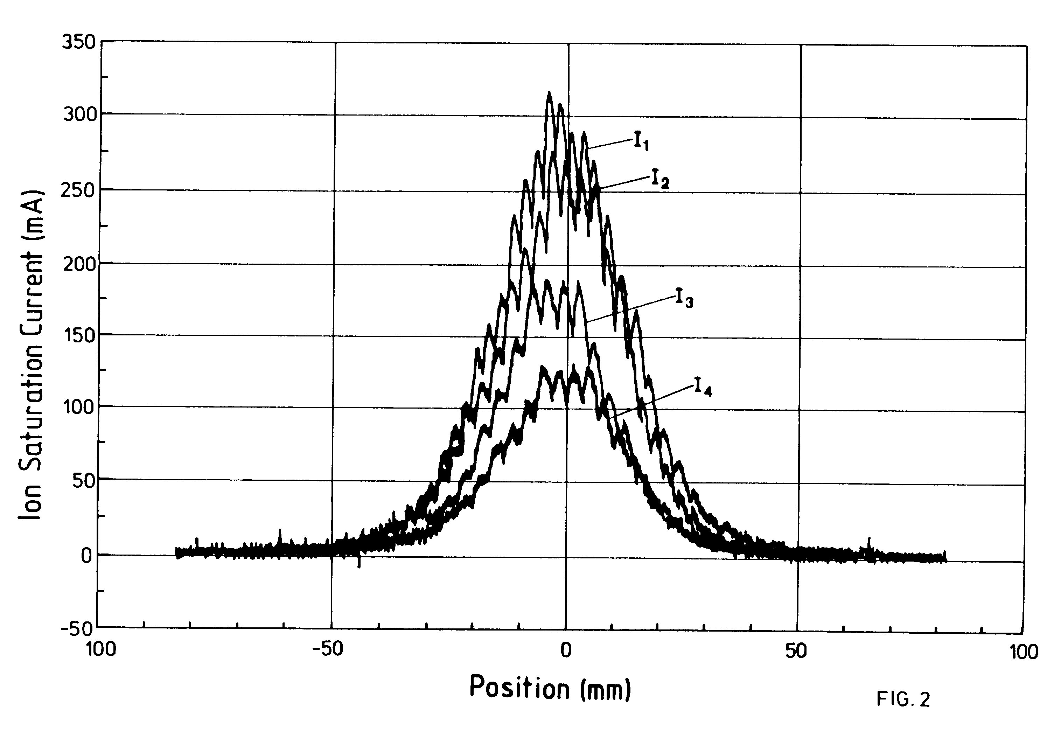

Fig. 2 zeigt die an einer Laboranlage gemessene Verteilung der Ionensättigungs-Stromdichte in einer Ebene E. Parameter der vier Kurven ist der Bogenstrom, wobei $I_1 > I_2 > I_3 > I_4$ ist. Die Ionensättigungs-Stromdichte ist ein Mass für die Plasmadichte. Man erkennt, dass die Plasmadichte in Form einer Gausskurve relativ rasch nach aussen hin abfällt, so dass die Plasmadichte in einem Radius r > 50mm nurmehr einige % der maximalen Plasmadichte im Bogenzentrum aufweist. Im Rahmen der besonders bevorzugten Realisation der vorliegenden Erfindung ist es wesentlich, dass die Werkstücke im Bereich solch geringer Plasmadichte angeordnet werden, weil sich die bei Hochstrombogen durchaus üblichen Schwankungen der Plasmadichte im Bereich solch geringer Plasmadichten nur geringfügig auswirken.

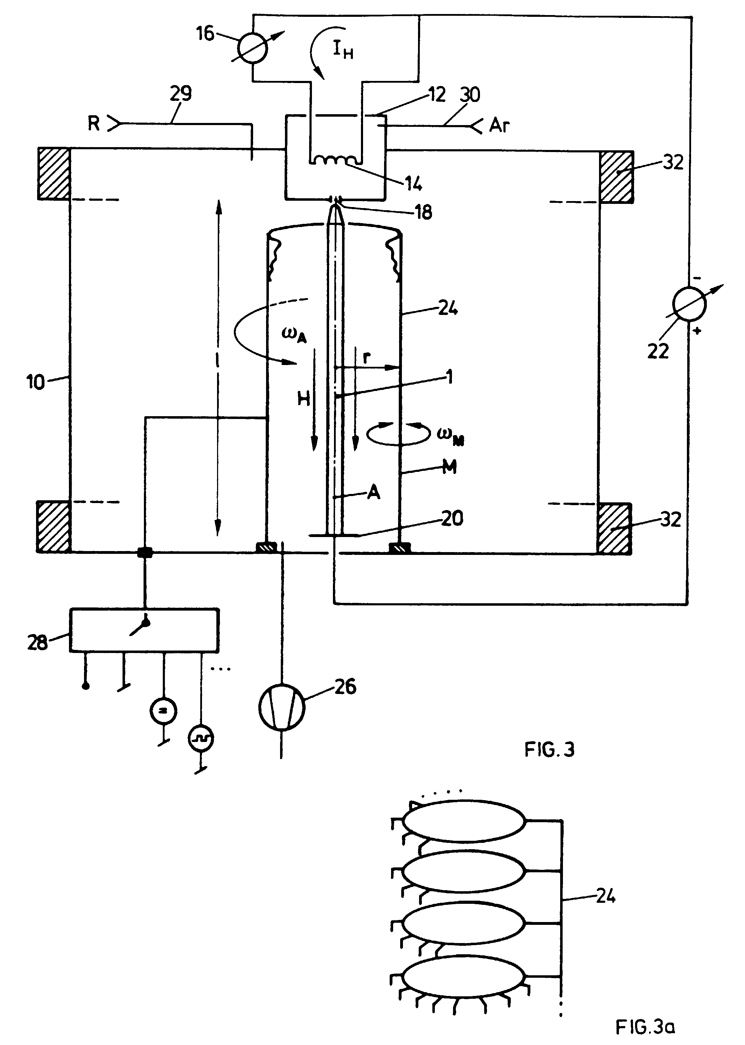

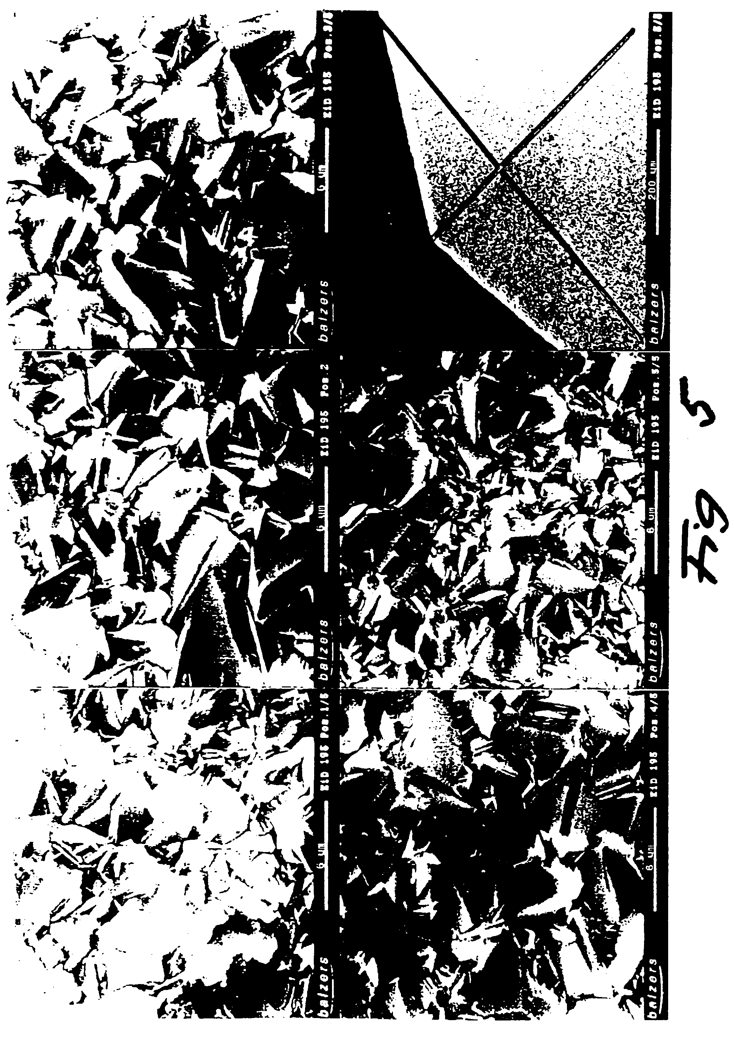

Die Breite des Plasmastrahls kann, wie in Fig. 2 dargestellt, über den Bogenstrom, aber auch über ein achsiales Magnetfeld, wie in Fig. 3 dargestellt, variiert werden.

Durch die Anordnung der Werkstücke im Bereich geringer Plasmadichte ergibt sich auch der Vorteil, dass die Plasmadichte entlang des homogenen Bereiches $\ell$ gemäss Fig. 1 nur geringfügig schwankt, so dass entlang des ganzen homogenen Bereiches $\ell$ Diamantschichten abgeschieden werden können.

Vorzugsweise sind die Werkstücke bzw. Substrate in einem Plasmadichtebereich angeordnet, der höchstens 20%, vorzugsweise höchstens 10%, vorzugsweise gar höchstens 5% der in Fig. 1 mit Max bezeichneten maximalen Plasmadichte beträgt.

Durch diese Anordnung gelingt es, eine Plasmaquelle und damit auch eine Quelle zur Erzeugung von atomarem H, wie es zur Behandlung, insbesondere zur Abscheidung metastabiler Schichten wichtig ist, mit grossem Volumen zu bilden. Durch die Rotationssymmetrie des Hochstrombogens und die geringen Schwankungen im homogenen Bereich $\ell$ ergibt sich eine Zylinderfläche F mit grossem Radius r und grosser Länge $\ell$, auf der eine grosse Zahl von Substraten homogen und reproduzierbar behandelt, insbesondere beschichtet werden kann.

Als charakteristische Grosse für die richtige Wahl des Abstandes der Werkstücke bzw. Substrate vom Bogenzentrum bei gegebener Bogenleistung kann folgende Beziehung angegeben werden:

$$P/A \geq 10W/cm^2, \text{ insbesondere } \geq 30W/cm^2,$$

wobei

P die Bogenleistung und
A die Behandlungs- bzw. Beschichtungsfläche bezeichnen.

Dabei wird als Behandlungs- bzw. Beschichtungsfläche diejenige Fläche des Rotationskörpers um die Strahlachse bezeichnet, auf der eine beabsichtigte Behandlung bzw. Beschichtung erreichbar ist.

Dabei werden die Substratträger möglichst transparent gestaltet, um bei gegebener Leistung eine möglichst grosse Fläche behandeln bzw. beschichten zu können.

Im weiteren kann es vorteilhaft sein, die Werkstücke entlang der Rotationsfläche F, insbesondere der Zylinderfläche, um die Strahlachse A zu drehen, wie dies bei $\omega_A$ in Fig. 1 angedeutet ist, und/oder Werkstükke bezüglich einer Mantellinie M rotieren zu lassen, wie dies mit $\omega_M$ angedeutet ist, und/oder die Gasströmung vom Einlass von Reaktivgas zur Gasabsaugung in der einen oder anderen Richtung parallel zur Strahlachse A zu realisieren, wie das mit dem Doppelpfeil G in Fig. 1 dargestellt ist.

Durch die letzterwähnten Dreh-Rotations- und/oder Gasflussmassnahmen wird zusätzlich eine Homogenisierung der Behandlung bzw. Beschichtung erzielt.

Im weiteren wird die Hochstrombogenbreite vorzugsweise gesteuert durch ein parallel zur Strahlachse A angelegtes Magnetfeld, wie auch in Fig. 1 mit H eingetragen.

Daraus sind bevorzugte Ausführungsvarianten bereits ersichtlich:

- Entlang den Mantellinien einer erfindungsgemäss für die Werkstückaufnahme eingesetzten Rotationsfläche F variiert die Plasmadichte vorzugsweise nicht mehr als 100%, vorzugsweise nicht mehr als 50%.

  Gegebenenfalls, insbesondere bei grösseren Plasmadichtevariationen, können diese durch Anordnen der Werkstücke entlang Trägerringen mit entsprechend unterschiedlichen Radien r berücksichtigt werden.

- In den achsensenkrechten Ebenen E liegen die jeweiligen Grosskreise K in einem Plasmadichtebereich, der höchstens 20%, vorzugsweise höchstens 10%, vorzugsweise gar höchstens 5% der Plasmadichtemaxima in den jeweils betrachteten Ebenen E ist.

In Fig. 3 ist eine erfindungsgemässe Anlage schematisch dargestellt. In einem Vakuumrezipienten 10 wird der Plasmastrahl 1, vorzugsweise als Hochstrombogenentladung erzeugt, vorzugsweise in Form einer Heisskathoden-Niederspannungs-Hochstrombogenentladung gemäss Fig. 2, wobei aber auch eine Kaltkathoden-Bogenentladung eingesetzt werden kann.

Am Vakuumrezipienten 10 ist eine Kathodenkammer 12 angeflanscht, mit einer elektronenemittierenden Heisskathode 14, die in einen Heizstromkreis für den Heizstrom $I_H$ mit vorzugsweise einstellbarem Heizstromgenerator 16 geschaltet ist.

Gegenüber einer an der Kathodenkammer 12 vorgesehenen Strahlaustrittsblende 18 ist die Anode 20 angeordnet. Zwischen Heisskathode 14 bzw. Heizstromkreis und Anode ist der vorzugsweise einstellbare Entladungsgenerator 22 geschaltet. Bezüglich Details dieser bekannten Anordnung kann beispielsweise auf die CH 664 768 verwiesen werden.

Es ist eine eine zylindrische Fläche definierende Werkstückträgeranordnung 24 vorgesehen. Der Radius r ist strahlleistungsabhängig. Bei gegebener Strahlleistung wird er so ermittelt, dass pro $cm^2$ für die Werkstückbehandlung- bzw. -beschichtung auszunützender Zylinderfläche eine Plasmastrahlleistung von mindestens $10W/cm^2$, vorzugsweise von mindestens $30W/cm^2$ erzielt wird.

Entlang der zylindrischen Werkstückträgeranordnung 24 werden zu behandelnde bzw. zu beschichtende Werkstücke, wie beispielsweise Bohrer, Wendeschneidplatten, Fräser etc. positioniert, wobei (in Fig. 2 nicht dargestellt) die gesamte zylindrische Anordnung 24 um die Strahlachse A, entsprechend $\omega_A$, gedreht werden kann oder die Werkstücke bezüglich Mantellinien M der zylinderförmigen Anordnung 24 rotiert werden können, $\omega_M$.

Um die Prozessgase möglichst effizient auszunützen, werden die Substratträger, wie in Fig. 3a dargestellt, möglichst transparent gebaut, so dass die Hauptfläche durch die Substrate selbst und nicht durch deren Halterungen gebildet wird.

Wie in Fig. 3 ersichtlich, wird Reaktivgas R kathodenseitig bei 29 in den Rezipienten 10 eingelassen, anodenseitig ist die Pumpanordnung 26 vorgesehen. Dadurch wird eine im wesentlichen parallel zur Achse A gerichtete Gasströmung durch den Rezipienten und entlang der die Zylinderfläche aufspannenden Werkstückträgeranordnung 24 erstellt. Ueber die Werkstückträgeranordnung 24 werden die Werkstücke entweder potentialfliegend betrieben oder auf ein Bezugspotential, beispielsweise Massepotential gelegt oder auf ein DC-Bias-Potential oder auf ein AC-Potential gelegt oder aber auf ein gemischtes AC+DC-Potential, wie beispielsweise auf ein gepulstes Potential. Diese und weitere Potentiallegungsmöglichkeiten für die Werkstücke sind in Fig. 3 schematisch mit der Umschalteinheit 28 dargestellt.

In die Kathodenkammer 12 wird in bekannter Art und Weise ein Arbeitsgas, wie Ar, durch eine Leitung 30 eingelassen.

Mittels einer Spulenanordnung 32 wird ein im wesentlichen achsparallel gerichtetes Magnetfeld H im Strahlbereich erzeugt, wodurch, gesteuert, die Divergenz des Strahles 1 bzw. dessen Plasmadichteverteilung entlang seiner Länge eingestellt werden kann.

Rückblickend auf die Erläuterungen zu Fig. 1, wurde die zylindrische Werkstückträgeranordnung 24 mit einem Radius r bezüglich der Strahlachse A bis hin zu ca. 1% Plasmadichte der jeweiligen Maximaldichte in der betrachteten Ebene E ausgelegt. Die Schwankung in Mantellinienrichtung dieser Plasmadichte war nicht mehr als 100%, vorzugsweise nicht mehr als 50%. Es gelang mit einer solchen Anordnung homogen sogar Diamantschichten höchster Güte abzuscheiden. Dies entlang der ganzen homogenen Bogenlänge $\ell$.

Es ist nun ersichtlich, dass durch Erzeugung eines langen Plasmastrahles 1 und der erfindungsgemässen Ausnützung eines Bereiches kleiner Plasmadichte gleichzeitig und damit äusserst wirtschaftlich eine Vielzahl von Werkstücken oder grosse Werkstückflächen homogen, grosstechnisch und wirtschaftlich behandelt, dabei insbesondere auch beschichtet werden können.

Aufgrund der extrem hohen Plasmadichte des Hochstrombogens ist der Bogen insbesondere dazu geeignet, Diamantschichten hoher Qualität grossflächig abzuscheiden. Das so erzeugte Plasma ist jedoch bestens dazu geeignet, ganz allgemein äusserst schwierig herstellbare Schichten, nämlich metastabile Schichten, wie cBN-, $\alpha$-$Al_2O_3$- und $C_3N_4$-Schichten, abzuscheiden. Ebenso eignet sich dieses Plasma in höchstem Masse zur Oberflächenreinigung oder sonstigen Oberflächenmodifikation von Werkstücken.

Für die folgenden Beispiele wurde eine Anlage, wie schematisch in Fig. 3 dargestellt, für Diamantbeschichtung, wie folgt ausgelegt und betrieben:

- **Bogenlänge** : 50 - 90cm
- **Verschiedene Werkstückträgeranordnungen:** 1 - 8 entlang der Bogenlänge zentrierte regelmässig verteilte Tragringe, je elektrisch isoliert gelagert. Der Durchmesser der Ringe war der jeweiligen Plasmaleistung angepasst.
- **Gasgemisch:** $Ar/H_2/CH_4$ im Verhältnis 52,2/47,1/0,7%
- **Totaldruck**: p = 80 - 200Pa
- **Bogenstrom:** I = 200 - 500A
- **Achsiales Magnetfeld im Strahlzentrum:** 50 - 200 Gauss.

**Beispiel 1:**

Fünf Ringe der Werkstückträgeranordnung (s. Fig. 3a) wurden mit Hartmetall-Wendeschneidplatten beladen, so dass insgesamt eine grosse Zahl von Platten behandelt wurde.

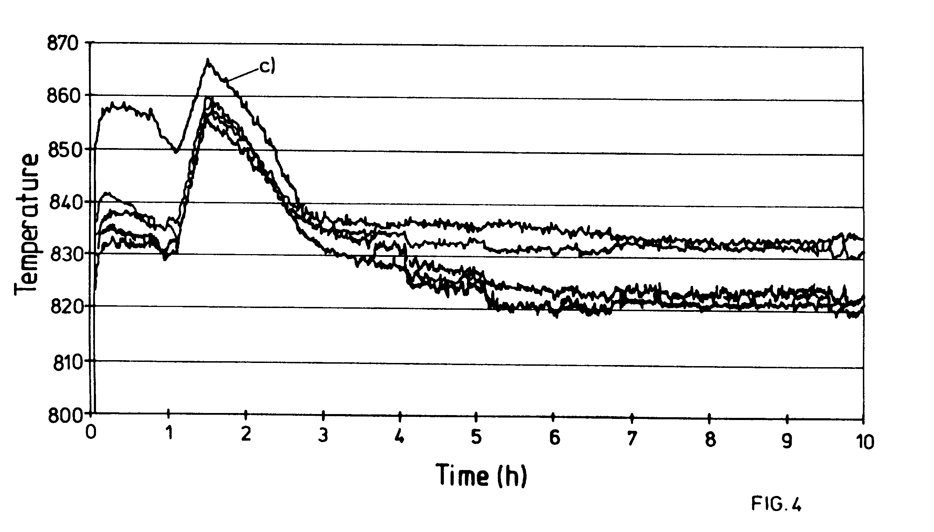

In Fig. 4 ist der Temperaturverlauf während der Behandlungszeit dargestellt, der wie nachfolgend definiert gemessen wurde. Die Temperatur wurde gemessen:

a) An einer Stelle auf dem anodenseitig untersten Ring, der ungefähr 15cm über der Anode angeordnet war;

b) am mittleren der einige cm voneinander beabstandeten Ringe, also ca. in Bogenmitte, an drei gleichmässig entlang dieses Ringes verteilten Messstellen, und schliesslich

c) am obersten ca. 15 bis 25cm von der Blende 18 gemäss Fig. 3 abgesetzten Ring.

Die letzterwähnte Messung ist in Fig. 4 durch den Verlauf c) dargestellt. Es ist ersichtlich, dass die Temperaturunterschiede in der Grössenordnung von 10° sind, bei einem mittleren Temperaturniveau von ca. 830°. Dies entspricht einer Temperaturvariation von ca. 1%: Der Prozess entlang Zylinder-Mantellinien und Grosskreisen ist ausgezeichnet homogen.

Auf allen Substraten wurden Diamantschichten abgelegt mit hervorragender Facettierung.

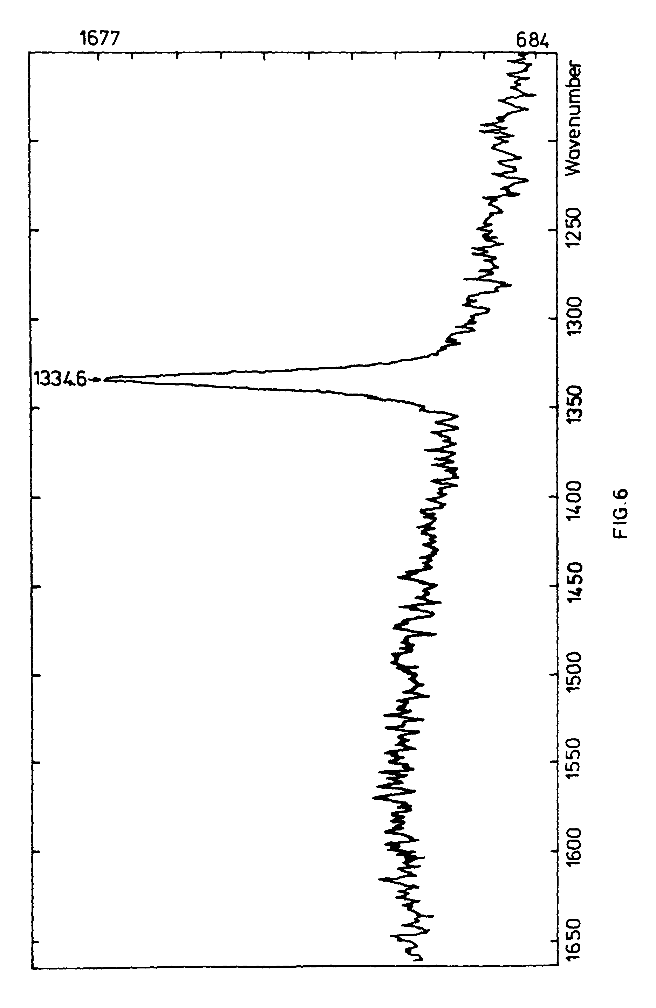

In Fig. 5 ist, ausser rechts unten, die gute Facettierung der Diamantschichten an jedem der fünf Ringe dargestellt, anhand von REM-Aufnahmen.

Fig. 6 zeigt das Raman-Spektrum der erfindungsgemäss abgelegten Diamantschicht: Es ist kein Graphitanteil erkenntlich. Dieser träte bei $1500cm^{-1}$ als breite Schulter auf.

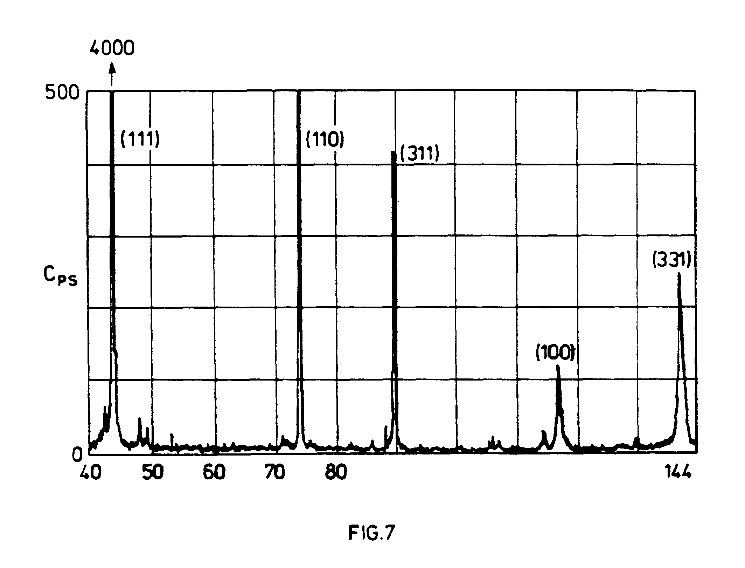

Fig. 7 zeigt ein Röntgenbeugungsspektrum der erfindungsgemäss hergestellten Diamantschicht auf den Hartmetallsubstraten bei streifendem Einfall: Alle grossen "peaks" entsprechen der Diamantbeschichtung bei den angegebenen kristallographischen Richtungen, die kleinen stammen von Hartmetallsubstrat.

Das Signal der (111)-Facettierung ist in Fig. 7 nicht vollständig wiedergegeben und betrug etwa 4x die maximale Amplitudenhöhe gemäss Fig. 7.

Das Verhältnis von Bogenleistung zu Beschichtungsfläche bzw. Fläche des Werkstückträger-Zylinders 24 gemäss Fig. 3, welches ein charakteristisches Mass für den erfindungsgemässen Prozess ist, betrug beim erwähnten Beispiel 47 bis $54W/cm^2$.

**Beispiel 2:**

Anstelle der Wendeschneidplatten von Beispiel 1 wurden Schaftfräser mit einem Durchmesser von 8mm auf 4 bezüglich der Strahllängsausdehnung $\ell$ zentrierten Ringen mit einigen cm Abstand angeordnet. Pro Ring wurde eine grosse Zahl Fräser radial angeordnet, mit gegen das Zentrum A gerichteter Spitze. Auf einer Länge von 40mm ab Fräserspitze wurde, mit leicht abnehmender Dicke, die Diamantschicht erzeugt. Es ist ersichtlich, dass auch Schaftwerkzeuge bis zu einer gewissen Schneidenlänge mit dem erfindungsgemässen Verfahren in grosser Stückzahl beschichtet werden können.

**Beispiel 3:**

Mit dem Verfahren, wie in Beispiel 1 dargelegt, wurden Hartmetallplatten ohne zusätzliche Kühlvorrichtung nahe am Plasmabogen, nämlich auf einem Radius von nur 60mm, angeordnet, bei einem Bogenstrom von 400A. Aufgrund der hohen Temperatur konnten nur schwarze, kohlenstoffartige Schichten und keine Diamantschichten abgeschieden werden.

Mit Bezug auf Beispiel 1 und Beispiel 2 können Werkstücke auch mit grösserem Abstand vom Plasmastrahl angeordnet werden, wobei entweder dessen Leistung zu erhöhen ist oder eine geringere Beschichtungsrate in Kauf zu nehmen ist.

Auch weitere, schwierig herstellbare metastabile Phasen, wie cBN oder $\alpha$-$Al_20_3$ oder $C_3N_4$, können erfindungsgemäss als Schichten abgelegt werden. Als Gase für die cBN-Abscheidung können z.B. BCℓ3 (Borchlorid), B2H6 (Diboran), B3N3H6 (Borazin) und als N-Träger N2 oder NH3 eingesetzt werden, für die $Al_20_3$-Schicht z.B. $AlCl_3$- oder Trimethylaluminium. Es kann aber B oder Al ebensogut auch über ein physikalisches Verfahren, wie z.B. Elektronenstrahlverdampfen oder thermisches Verdampfen, in den Reaktionsraum eingebracht werden.

Mithin wurde grundsätzlich gefunden, dass sich der Diffusionsbereich von Hochstrombogenentladungen, d.h. der Bereich mit einer Plasmadichte $\leq 20\%$ der Strahlzentrums-Plasmadichte, ausserordentlich gut für die Abscheidung von extrem harten Schichten eignet, insbesondere für die Abscheidung von Schichten aus unter Normalbedingungen schwierig herstellbaren metastabilen Phasen, wie Diamant-, cBN-, $\alpha$-$Al_20_3$- und $C_3N_4$-Schichten. Entlang einer grossen Bogenlänge herrschen bei diesen Dichteverhältnissen weitgehend homogene Bedingungen, so dass unter optimaler Ausnützung einer Hochstrombogenentladung optimal viele Werkstücke gleichzeitig beschichtet werden können.

Insbesondere ergibt sich aus der Anordnung der Substrate in einen Bereich sehr geringer Plasmadichte der Vorteil, dass das Plasmadichteprofil (s. Fig. 2) sehr flach ist und damit nurmehr eine schwache Abhängigkeit der Plasmadichte von der radialen Position vorliegt. Indessen wird der Radius der Substratträgerringe (Fig. 3a) so gewählt, dass keine Kühlung der Substrate erforderlich ist, welche bei hohen Temperaturen von 800°C sehr aufwendig wäre.

Obwohl im vorliegenden Zusammenhang der Hochstrombogen als Heisskathoden-Niederspannungsentladung oder Kaltkathoden-Entladung erzeugt wurde, ist es durchaus möglich, dass auch ein Plasmajet im Sinne der vorliegenden Erfindung als Plasmastrahl eingesetzt wird. Bezüglich Realisation von Plasmajets wird vollumfänglich beispielsweise auf J. Electrochem Soc., Vol. 137, No. 2, Febr. 1990, S. 717 - 722 verwiesen.

## Patentansprüche

1. Verfahren zur reaktiven Behandlung von Werkstükken, bei dem ein Plasmastrahl (1) in einem evakuierten Rezipienten (10) erzeugt wird und, bezüglich des Bereiches höchster Plasmadichte entlang der Strahlachse (A), radial versetzt, Werkstücke angeordnet werden, wobei frisches Reaktivgas (R) in den Rezipienten (10) eingelassen und verbrauchtes aus dem Rezipienten abgesaugt wird und gleichzubehandelnde Werkstückoberflächen, entlang einer längsausgedehnten Fläche verteilt, um den Plasmastrahl angeordnet werden, dadurch gekennzeichnet, dass die Werkstückoberflächen, betrachtet in Ebenen (E) senkrecht zur Strahlachse (A), bezüglich der Strahlachse (A) so radial versetzt angeordnet werden, dass sie in einem Plasmadichtebereich liegen, der eine Plasmadichte von höchstens 20 % des Plasmadichtemaximums in der betrachteten Ebene (E) aufweist.

2. Verfahren nach Anspruch 1, dadurch gekennzeichnet, dass die Behandlung eine Schichtabscheidung ist.

3. Verfahren nach einem der Ansprüche 1 oder 2, dadurch gekennzeichnet, dass der Plasmastrahl (1) als Niedervoltbogenentladung, vorzugsweise als Hochstrombogenentladung ausgebildet wird.

4. Verfahren nach einem der Ansprüche 1 bis 3, dadurch gekennzeichnet, dass als Rotationsfläche (F) eine die Strahlachse (A) umschliessende Fläche vorgesehen ist, vorzugsweise eine Zylinderfläche (24).

5. Verfahren nach einem der Ansprüche 1 bis 4, dadurch gekennzeichnet, dass die Werkstückoberflächen in einem Plasmadichtebereich liegen, der 10%, vorzugsweise gar höchstens 5% der Plasmadichtemaxima (Max) in der betrachteten Ebene (E) beträgt.

6. Verfahren nach einem der Ansprüche 1 bis 5, dadurch gekennzeichnet, dass die Werkstücke ringförmig um die Achse (A) angeordnet werden, vorzugsweise stationär.

7. Verfahren nach einem der Ansprüche 1 bis 6, dadurch gekennzeichnet, dass die Werkstücke entlang der Rotationsfläche (F) gedreht ($\omega_A$) und/oder bezüglich Mantellinien (M) der Rotationsfläche rotiert ($\omega_A$) werden und/oder eine im wesentlichen zur Strahlachse (A) parallele Gasströmung (G) im Rezipienten erstellt wird.

8. Verfahren nach einem der Ansprüche 1 bis 7, dadurch gekennzeichnet, dass man die Plasmadichteverteilung mittels eines im wesentlichen achsparallelen Magnetfeldes (H) steuert.

9. Verfahren nach einem der Ansprüche 1 bis 8, dadurch gekennzeichnet, dass man den Plasmastrahl vorzugsweise als Hochstrombogen mittels einer Heisskathoden-Entladung mit Kathodenkammer (12) mit Austrittsblende (18) erzeugt und die Werkstücke entlang der Rotationsfläche (F, 24) zwischen einer ersten Position, einige cm, vorzugsweise ca. 15cm, von der Anode beabstandet und einer zweiten Position, einige cm, vorzugsweise ca. 10cm, von der Austrittsblende (18) beabstandet.

**10.** Verfahren nach einem der Ansprüche 1 bis 9, dadurch gekennzeichnet, dass man die Werkstücke potentialfliegend oder auf ein vorzugsweise einstellbares elektrisches Potential, dabei auf ein DC-, ein AC- oder ein AC+DC-Potential legt.

**11.** Verfahren nach einem der Ansprüche 1 bis 10, dadurch gekennzeichnet, dass man den Plasmastrahl (1) mittels einer Niederspannungs-Bogenentladung mit Heisskathode oder mit Kaltkathode erzeugt, vorzugsweise als Hochstrombogenentladung.

**12.** Verfahren nach einem der Ansprüche 1 bis 11, dadurch gekennzeichnet, dass man den Druck im Rezipienten (10) zwischen 10Pa und $10^5$Pa (beide Grenzen eingeschlossen) wählt, vorzugsweise zwischen 10Pa und 1000Pa (beide Grenzen eingeschlossen).

**13.** Verfahren nach einem der Ansprüche 1 bis 12, dadurch gekennzeichnet, dass man die elektrische Entladungsleistung des Plasmastrahls pro Flächeneinheit vorgegeben beschichtbarer Fläche zu mindestens 10W/$cm^2$ wählt, vorzugsweise zu mindestens 30W/$cm^2$, und vorzugsweise den Plasmastrahl als Hochstrombogenentladung ausbildet.

**14.** Verwendung des Verfahrens nach einem der Ansprüche 1 bis 13 für die Abscheidung von metastabilen Schichten, wie von cBN-Schichten oder von $\alpha$-$Al_20_3$- oder $C_3N_4$-Schichten und insbesondere von Diamantschichten.

**15.** Verwendung des Verfahrens nach einem der Ansprüche 1 bis 13 für die Erzeugung von reaktiven chemischen Verbindungen, insbesondere von freien Radikalen, zur Oberflächenbehandlung.

**16.** Vakuumbehandlungsanlage mit einer Anordnung (3, 5; 14, 20), die einen vorgebbaren Plasmastrahl erzeugt, einem Gaseinlass (29), der mit einem Reaktivgas- (R) -Vorrat verbunden ist, einer von der Achse (A) des durch die Anordnung erzeugten Plasmastrahls (1) radial abgesetzten, achsial ausgedehnten Werkstückträgeranordnung (24) sowie einer Gasabsaugung (26), bei der die Werkstückträgeranordnung (24) eine zur Achse (A) des Plasmastrahls (1) koaxiale Rotationsfläche (F) aufspannt, dadurch gekennzeichnet, dass der kleinste Radius (r) der Rotationsflächen-Grosskreise im Plasmadichtebereich des Plasmastrahls (1) liegt, mit höchstens 20% der maximalen Plasmadichte (Max) in der jeweils betrachteten Grosskreisebene (E).

**17.** Anlage nach Anspruch 16, dadurch gekennzeichnet, dass die Rotationsfläche (F) eine Zylinderfläche (24) ist.

**18.** Anlage nach einem der Ansprüche 16 oder 17, dadurch gekennzeichnet, dass die Erzeugungsanordnung eine Niedervoltbogenentladung, vorzugsweise mit Heisskathode (14) oder mit Kaltkathode erzeugt, vorzugsweise eine Hochstrombogenentladung.

**19.** Anlage nach einem der Ansprüche 16 bis 18, dadurch gekennzeichnet, dass eine Anordnung (32) zur Erzeugung eines achsparallelen Magnetfeldes (H) entlang mindestens eines wesentlichen Bereiches des Plasmastrahls (1) vorgesehen ist.

**20.** Anlage nach einem der Ansprüche 16 bis 19, dadurch gekennzeichnet, dass beim Betrieb der Anlage die Werkstückträgeranordnung (24) auf fliegendem elektrischem Potential ist oder auf eine einstellbare DC- oder AC- oder AC+DC-Quelle geschaltet ist.

**21.** Anlage nach Anspruch 18, dadurch gekennzeichnet, dass sich die achsiale Ausdehnung der Rotationsfläche zwischen Positionen ca. 15cm vor der Anode und ca. 10cm nach der Blende einer Kathodenkammer (12) für eine Heisskathodenentladung erstreckt.

**22.** Anlage nach einem der Ansprüche 16 bis 21, dadurch gekennzeichnet, dass der kleinste Radius (r) der Rotationsflächen-Grosskreise im Plasmadichtebereich des Plasmastrahls (1) liegt, mit höchstens 10%, vorzugsweise gar mit höchstens 5% Plasmadichte bezüglich der maximalen Plasmadichte (Max) in der jeweils betrachteten Grosskreisebene (E).

**23.** Verwendung der Anlage nach einem der Ansprüche 16 bis 22 zur Abscheidung von Schichten, insbesondere von metastabilen Schichten, wie von cBN-Schichten oder von $\alpha$-$Al_20_3$- oder $C_3N_4$-Schichten und insbesondere von Diamantschichten.

**24.** Verwendung der Anlage nach einem der Ansprüche 16 bis 22 für die Erzeugung von reaktiven chemischen Verbindungen, insbesondere von freien Radikalen, zur Oberflächenbehandlung.

**Claims**

1. Process for reactive treatment of workpieces in which a plasma beam (1) is generated in an evacuated recipient (10), and workpieces are arranged radially offset along the beam axis (A) in relation to the area of maximum plasma density, where fresh reactive gas (R) is introduced into the recipient (10) and used gas extracted from the recipient, and workpiece surfaces to be treated equally are arranged about the plasma beam spread along a longitudinally extended surface, characterised in that the workpiece surfaces, viewed in plane (E) perpendicular to the beam axis (A), are arranged radially offset in relation to the beam axis (A) so that they lie in a plasma density area which has a plasma density of maximum 20% of the maximum plasma density in the plane (E) concerned.

2. Process according to claim 1, characterised in that the treatment is a layer deposition treatment.

3. Process according to any of claims 1 or 2, characterised in that the plasma beam (1) is formed as a low voltage are discharge, preferably as a heavy current arc discharge.

4. Process according to any of claims 1 to 3, characterised in that as a rotational surface (F), a surface surrounding the beam axis (A) is provided, preferably a cylindrical surface (24).

5. Process according to any of claims 1 to 4, characterised in that the workpiece surfaces lie in a plasma density area which amounts to 10%, preferably maximum 5%, of the maximum plasma density (Max) in the plane (E) concerned.

6. Process according to any of claims 1 to 5, characterised in that the workpieces are arranged in a ring form about the axis (A), preferably stationary.

7. Process according to any of claims 1 to 6, characterised in that the workpieces are turned ($\omega_A$) along the rotational. surface (F) and/or rotated ($\omega_A$) in relation to the generating lines (M) of the rotational surface and/or a gas flow (G) essentially parallel to the beam axis (A) is generated in the recipient.

8. Process according to any of claims 1 to 7, characterised in that the plasma density distribution is controlled by means an essentially co-axial magnetic field (H).

9. Process according to any of claims 1 to 8, characterised in that the plasma beam is preferably generated as a heavy current arc by means of a hot cathode discharge with cathode chamber (12) with emission diaphragm (18) and the workpieces placed at intervals along the rotational. surface (F, 24) between a first position a few cm, preferably approx 15 cm, from the anode and a second position a few cm, preferably approx 10 cm, from the emission diagraphm (18).

10. Process according to any of claims 1 to 9, characterised in that the workpieces are connected to floating potential or a preferably adjustable electric potential, a DC, AC or AC+DC potential.

11. Process according to any of claims 1 to 10, characterised in that the plasma beam (1) is generated by means of a low voltage arc discharge with hot cathode or cold cathode, preferably as a heavy current arc discharge.

12. Process according to any of claims 1 to 11, characterised in that the pressure in the recipient (10) is selected between 10 Pa and $10^5$ PA (both limits included), preferably between 10 Pa and 1000 Pa (both limits included).

13. Process according to any of claims 1 to 12, characterised in that the electric discharge power of the plasma beam per surface unit of given coatable surface is selected as minimum 10 W/cm$^2$, preferably at least 30 W/cm$^2$, and preferably the plasma beam is formed as a heavy current arc discharge.

14. Use of the process according to any of claims 1 to 13 for depositing metastable layers such as cBN layers or $\alpha$-$Al_2O_3$ or $C_3N_4$ layers and in particular diamond layers.

15. Use of the process according to any of claims 1 to 13 to generate reactive chemical compounds, in particular free radicals, for surface treatment.

16. Vacuum processing device with an arrangement (3, 5; 14, 20) which generates a prespecifiable plasma beam, a gas inlet (29) which is connected with a reactive gas (R) store, a workpiece carrier arrangement (24) extended axially and radially offset from axis (A) of the plasma beam (1) generated by the device, and a gas extractor (26), where the workpiece carrier arrangement (24) mounts a rotational surface (F) coaxial to axis (A) of the plasma beam (1), characterised in that the minimum radius (r) of the rotational surface great circle lies in the plasma density area of the plasma beam (1) with maximum 20% of the maximum plasma density (Max) in the great circle plane (E) concerned.

17. Device according to claim 16, characterised in that the rotational surface (F) is a cylinder surface (24).

**18.** Device according to any of claims 16 or 17, characterised in that the generation device generates a low voltage are discharge, preferably with hot cathode (14) or cold cathode, preferably a heavy current arc discharge.

**19.** Device according to any of claims 16 to 18, characterised in that an arrangement (32) is provided to generate a co-axial magnetic field (H) along at least one essential area of the plasma beam (1).

**20.** Device according to any of claims 16 to 19, characterised in that on operation of the system the workpiece carrier arrangement (24) is connected to floating electrical potential or an adjustable DC or AC or AC+DC source.

**21.** Device according to claim 18, characterised in that the axial extension of the rotational surface extends between positions approx 15 cm in front of the anode and approx 10 cm after the diaphragm of a cathode chamber (12) for a hot cathode discharge.

**22.** Device according to any of claims 16 to 21, characterised in that the minimum radius (r) of the rotational surface great circle lies in the plasma density area of the plasma beam (1) with maximum 10%, preferably maximum 5% plasma density in relation to the maximum plasma density (Max) in the great circle plane (E) concerned.

**23.** Use of the device according to any of claims 16 to 22 to deposit layers, in particular metastable layers such as cBN layers or $\alpha$-$Al_2O_3$ or $C_3N_4$ layers and in particular diamond layers.

**24.** Use of the device according to any of claims 16 to 22 to generate reactive chemical compounds, in particular free radicals, for surface treatment.

**Revendications**

**1.** Procédé pour le traitement réactif de pièces, dans lequel un jet de plasma (1) est produit dans un récipient (10) dans lequel on a fait le vide, et les pièces sont déportées radialement par rapport à la région de densité maximum du plasma, le long de l'axe (A) du jet, du gaz réactif neuf (R) étant introduit dans le récipient (10) et le gaz réactif usé étant aspiré hors du récipient, et les surfaces des pièces qui doivent être traitées de la même façon étant disposées autour du jet de plasma réparties le long d'une surface, caractérisé en ce que les surfaces des pièces, considérées dans des plans (E) perpendiculaires à l'axe (A) du jet, sont déportées radialement par rapport à l'axe (A) du jet de telle manière qu'elles se trouvent dans une région de densité de plasma qui présente une densité de plasma qui est au plus de 20 % du maximum de densité du plasma dans le plan (E) considéré.

**2.** Procédé selon la revendication 1, caractérisé en ce que le traitement est une ablation de couches.

**3.** Procédé selon la revendication 1 ou 2, caractérisé en ce que le jet de plasma (1) est constitué par une décharge en arc à basse tension, de préférence une décharge en arc à haute intensité.

**4.** Procédé selon l'une des revendications 1 à 3, caractérisé en ce qu'il est prévu, comme surface de rotation (F), une surface qui entoure l'axe (A) du jet, de préférence une surface cylindrique (24).

**5.** Procédé selon l'une des revendications 1 à 4, caractérisé en ce que les surfaces des pièces se trouvent dans une région de densité de plasma qui représente 10 %, de préférence même au plus 5 % des maxima (max) de densité du plasma dans le plan considéré (E).

**6.** Procédé selon l'une des revendications 1 à 5, caractérisé en ce que les pièces sont disposées en couronne autour de l'axe (A), de préférence en position stationnaire.

**7.** Procédé selon l'une des revendications 1 à 6, caractérisé en ce que les pièces sont entraînées en rotation ($\omega_A$) le long de la surface de rotation (F) et/ou mises en rotation ($\omega_A$) par rapport aux génératrices (M) de la surface de rotation, et/ou un écoulement gazeux (G) sensiblement parallèle à l'axe (A) du jet est établi dans le récipient.

**8.** Procédé selon l'une des revendications 1 à 7, caractérisé en ce que la répartition de la densité du plasma est commandée au moyen d'un champ magnétique (H) sensiblement parallèle à l'axe.

**9.** Procédé selon l'une des revendications 1 à 8, caractérisé en ce qu'on produit le jet de plasma, de préférence en arc à haute intensité, au moyen d'une décharge à cathode chaude, avec une chambre de cathode (12) munie d'un diaphragme de sortie (18) et on place les pièces le long de la surface de rotation (F, 24) entre une première position, espacée de quelques cm, de préférence d'environ 15 cm, de l'anode, et une deuxième position espacée de quelques cm, de préférence 10 cm, du diaphragme de sortie (18).

**10.** Procédé selon l'une des revendications 1 à 9, caractérisé en ce qu'on place les pièces sur un potentiel volant ou sur un potentiel électrique de préférence réglable, sur un potentiel continu, alternatif ou alternatif plus continu.

**11.** Procédé selon l'une des revendications 1 à 10, caractérisé en ce qu'on produit le jet de plasma (1) au moyen d'une décharge en arc à basse tension avec cathode chaude ou avec cathode froide, de préférence sous la forme d'une décharge en arc à haute intensité.

**12.** Procédé selon l'une des revendications 1 à 11, caractérisé en ce qu'on choisit pour la pression dans le récipient (10) une valeur située entre 10 Pa et $10^5$ Pa (les deux limites incluses), de préférence entre 10 Pa et 1000 Pa (les deux limites incluses).

**13.** Procédé selon l'une des revendications 1 à 12, caractérisé en ce que pour la puissance de décharge électrique du jet de plasma par unité de surface d'une surface pouvant être revêtue prédéterminée on choisit au moins 10 $W/cm^2$, de préférence une valeur d'au moins 30 $W/cm^2$ et on donne de préférence au jet de plasma la forme d'une décharge en arc à haute intensité.

**14.** Utilisation du procédé selon l'une des revendications 1 à 13, pour l'ablation de couches métastables comme des couches de cBN ou de $\alpha$-$Al_20_3$ ou de $C_3N_4$ et, en particulier de couches de diamant.

**15.** Utilisation du procédé selon l'une des revendications 1 à 13 pour la production de composés chimiques réactifs, en particulier de radicaux libres pour le traitement des surfaces.

**16.** Installation de traitement sous vide comportant un dispositif (3, 5 ; 14, 20) qui produit un jet de plasma pouvant être prédéterminé, une entrée de gaz (29) qui est reliée à une réserve de gaz réactif (R), un dispositif support de pièces (24) qui est décalé radialement par rapport à l'axe (A) du jet de plasma (1) produit par le dispositif et qui est allongé dans la direction axiale, ainsi qu'une aspiration de gaz (26) dans laquelle le dispositif support de pièces (24) couvre une surface de rotation (F) coaxiale par rapport à l'axe (A) du jet de plasma (1), caractérisée en ce que le rayon minimum (r) des grands cercles de la surface de rotation se trouve dans la région de densité de plasma du jet de plasma (1) qui possède au maximum 20 % de la densité maximale du plasma (Max) dans le plan de grand cercle (E) considéré.

**17.** Installation selon la revendication 16, caractérisée en ce que la surface de rotation (F) est une surface cylindrique (24).

**18.** Installation selon la revendication 16 ou 17, caractérisée en ce que le dispositif de production produit une décharge en arc à basse tension, de préférence avec cathode chaude (14) ou cathode froide, de préférence une décharge en arc à haute intensité.

**19.** Installation selon l'une des revendications 16 à 18, caractérisé en ce qu'il est prévu un dispositif (32) pour produire un champ magnétique (H) parallèle à l'axe le long d'au moins une région importante du jet de plasma (1).

**20.** Installation selon l'une des revendications 16 à 19, caractérisée en ce que lors du fonctionnement l'exploitation de l'installation, le dispositif support de pièces (24) est sous un potentiel électrique volant ou commuté sur une source de tension continue, alternative ou alternative plus continue, réglable.

**21.** Installation selon la revendication 18, caractérisée en ce que l'extension axiale de la surface de rotation s'étend entre des positions situées à environ 15 cm devant l'anode et environ 10 cm au-delà du diaphragme d'une chambre de cathode (12) prévue pour une décharge à cathode chaude.

**22.** Installation selon l'une des revendications 16 à 21, caractérisée en ce que le rayon minimum (r) des grands cercles de la surface de rotation se trouve dans la région de densité du plasma du jet de plasma (1) possédant au maximum 10 %, de préférence même au maximum 5 %, de densité de plasma comparativement à la densité de plasma maximale (Max) dans le plan de grand cercle (E) considéré.

**23.** Utilisation de l'installation selon l'une des revendications 16 à 22 pour l'ablation de couches, en particulier de couches métastables comme des couches cBN ou de $\alpha$-$Al_20_3$ ou de $C_3N_4$, et en particulier des couches de diamant.

**24.** Utilisation du procédé selon l'une des revendications 16 à 22 pour la production de combinaisons chimiques réactives, en particulier de radicaux libres, pour le traitement des surfaces.

2
3
~10 cm
Max.
E
F
H
l
G
r
1
$\omega_M$
A
$\omega_A$
~15 cm
4

FIG.1

Ion Saturation Current (mA)
350
300
250
200
150
100
50
0
-50
Position (mm)
100
-50
0
50
100
$I_1$
$I_2$
$I_3$
$I_4$

FIG. 2

16
$I_H$
29
12
30
R
Ar
32
14
18
24
$\omega_A$
22
r
10
1
H
$\omega_M$
M
A
20
32
28
26

FIG. 3

FIG.3a

Fig 5

Temperature
870
860
850
840
830
820
810
800
Time (h)
0
1
2
3
4
5
6
7
8
9
10
c)

FIG. 4

1677
684
Wavenumber
1250
1300
1334.6
1350
1400
1450
1500
1550
1600
1650

FIG.6

4000
500
(111)
(110)
(311)
Cps
(331)
(100)
0
40
50
60
70
80
144

FIG.7